# EUROPEAN PATENT SPECIFICATION

(11) **EP 3 492 866 B1**
(45) Date of publication and mention of the grant of the patent: **01.12.2021**
(21) Application number: 17382812.0
(22) Date of filing: 01.12.2017
(51) Int. Cl.: G01C 19/5698, B33Y 80/00, B29C 64/00, H05K 3/00, H05K 3/12, H05K 3/46

(54) **MANUFACTURING PROCESS OF A POSITIONING CONTROL TOOL VIA 3D-PRINTING TECHNOLOGY**
HERSTELLUNGSVERFAHREN EINES POSITIONIERUNGSSTEUERUNGSWERKZEUGS ÜBER 3D-DRUCKTECHNOLOGIE
PROCÉDÉ DE FABRICATION D'UN OUTIL DE CONTRÔLE DE POSITIONNEMENT VIA LA TECHNOLOGIE D'IMPRESSION 3D

(43) Date of publication of application: 05.06.2019
(73) Proprietor: Airbus Operations, S.L., 28906 Getafe (ES)
(72) Inventor: JARA RODELGO, Alvaro, 28906 Getafe (ES); LLORENTE GARCIA, Paloma, 28906 MADRID (ES); TORRES SALAS, Alvaro, 28906 MADRID (ES); MOYA SANZ, Elena, 28906 MADRID (ES)

(56) References cited:
- US-A1- 2003 167 841
- US-A1- 2009 133 495
- US-A1- 2016 242 296
- US-A1- 2017 334 139
- KENNETH H CHURCH ET AL: "Advanced Printing for Microelectronic Packaging", IPC APEX EXPO 2014, 1 January 2014 (2014-01-01), XP055474085,

## Description

### FIELD OF THE INVENTION

The present invention relates to a smart tool and a manufacturing process of this tool. More specifically, the invention is relative to a manufacturing process of a positioning control tool via 3D-printing technology.

### BACKGROUND

Gyroscopes are well known in the state of art and are include in some devices used for measuring or maintaining orientation and angular velocity. Nowadays gyroscope found some applications in ships, aircrafts, spacecraft, or vehicles industry, but also in mobile phones, bicycles, joysticks, goggle glass, robots, etc...

For any mechanical gyroscope, there is a stable reference vibrating motion (V) of a mass (m) such as an angular rotation (Ω) perpendicular to the direction of the vibrating motion (V) causes a Coriolis force perpendicular to the directions of both the vibrating motion (V) and the angular rotation (Ω), at the frequency of the vibrating motion (V). Therefore, the effect of the Coriolis force F=2.m.V×Ω is a measure of the rate of the angular rotation (Ω).

A mass constrained by a stiffness element in a frame can be placed into an oscillatory motion in a z-direction by an input power source. If the frame is rotated about an x-axis, the oscillatory mass will experience a Coriolis force, in a y-direction, proportional to the applied rate of rotation. The Coriolis force acting on the mass attempts to cause a displacement of the mass in the y-direction proportional to the rate of rotation.

A conventional MEM (Micro-Electro-Mechanical) gyroscope is a silicon-based vibratory sensor that utilizes an energy transfer between two vibrating modes of a mechanical structure. To achieve high sensitivity when subjected to a rotation, the energy from the vibrating modes must be efficiently transferred at a high Q level from exciting direction to a sensing direction. A considerable effort is required to design and fabricate the vibrating structure and its support electronics to achieve a resolution of less than one degree per second.

Conventional MEM gyroscopes suffer from an inherent performance limitation because of their underlying operating principle, which is based on a vibration of suspended mechanical structure, i.e., a comb structure, a beam, a disk, or a ring structure. It is often difficult and expensive to design and fabricate a mechanical structure with matching resonant frequencies of the two vibrating modes. The cost of the final product may also increase due to a need for electronic circuitry for controlling and detecting the status of the vibrating structure in order to improve dynamic range. In addition, the suspended vibrating mechanical structure is susceptible to external shock and vibration that occurs at frequencies not far removed from the frequency at which the gyroscope operates. Such disturbances can influence the vibrating structure. Consequently, the structure cannot be rigidly attached to the substrate for its resonant vibration, thereby also limiting its dynamic range.

Document US2003167841 A1 describes a gyroscope that comprises a piezoelectric substrate having a surface. Disposed on the surface are a resonator transducer, a pair of reflectors, a structure such as a metallic dot, and a sensor transducer. The resonator transducer creates a first surface acoustic wave on the surface. The pair of reflectors reflects the first surface acoustic wave to form a standing wave within a region of the surface between the pair of reflectors. The structure is disposed on the surface within the region, wherein a Coriolis force acting upon the structure creates a second surface acoustic wave. The sensor senses the second surface acoustic wave and provides an output indicative thereof.

Document "Advanced Printing for Microelectronic Packaging" by Kenneth H. Church et al. focus on the use of micro-dispensing with exceptional volume control to print in 3D space with a wide variety of materials, including solders, epoxies, conductive adhesives and ceramic filled polymers. These can be used to build 3D structures and utilizing 3D Printing approach known as Computer Aided Design and Computer Aided Manufacturing (CAD/CAM).

Document US2017334139 A1 relates to a method for manufacturing a 3D mechatronic object having predetermined mechatronic functions, which includes as components at least one sensor and/or one actuator, an electronic circuit connected to the sensor and/or to the actuator via electrically conductive tracks, these components positioned in a main mechanical structure, and which consists of multiple polymers having various electronic and/or electroactive properties. The method follow the steps: determining the polymers according to their melting temperature, chemical compatibility, electrical and/or electroactive properties; determining a 3D digital model of the object, including its shape and the routing of the tracks, on the basis of predetermined mechatronic functions of the object, properties of the polymers and specifications of the object; 3D-printing the sensor and/or the actuator, the electronic circuit and the main structure in the same modeling steps according to the generated model by depositing layers of the molten polymers, certain layers being made up of a plurality of polymers, the layers being deposited by means of at least one head dedicated to a base polymer and coupled to a doping mechanism capable of injecting charged particles into the base polymer by interstitial doping so as to obtain the various polymers.

Document US2016242296 A1 relates to a method and apparatus for the additive fabrication of single and multi-layer electronic circuits by using directed local deposition of conductive, insulating, and/or dielectric materials to build circuit layers incorporating conductive, insulating and/or dielectric features, including inter-layer vias and embedded electronic components. Different conductive, insulating, and/or dielectric materials can be deposited at different points in the circuit such that any section of the circuit may be tailored for specific electrical, thermal, or mechanical properties. This enables more geometric and spatial flexibility in electronic circuit implementation, which optimizes the use of space such that more compact circuits can be manufactured.

### SUMMARY OF THE INVENTION

The present invention proposes a manufacturing process of a positioning control tool via 3D-printing technology, according to the set of claims, comprising the following steps in order to form a gyroscope:
- 3D-print a first part of framework with an insulating 3D-printing polymer material, such as to form a recipient laid on the print bed,
- 3D-print a set of layers of piezoelectric substrate inside the first part of framework based on a polymer material mixed with powdered graphene inside said first part of framework;
- 3D-print a pattern having a plurality of apertures therethrough;
- 3D-print with a polymer material mixed with powdered graphene, using said pattern, a plurality of features on said substrate, said features comprising:
   - a resonator transducer for creating a first surface acoustic wave on said surface of the piezoelectric substrate;
   - a pair of reflectors for reflecting said first surface acoustic wave to form a standing wave within a first region of said surface between said pair of reflectors;
   - a structure within said region, wherein a Coriolis force acting upon said structure creates a second surface acoustic wave; and
   - a first sensor transducer disposed on said surface for sensing said second surface acoustic wave; and
   - a second sensor transducer disposed on said surface for sensing a residual surface acoustic wave from a second region of said surface that is free of any structure that said Coriolis force can act upon, and for providing an output indicative of said residual surface acoustic wave;
- 3D-print a second part of framework with an insulating 3D-printing polymer material, such as to form a framework to protect and guaranty the working of the piezoelectric substrate with the features embedded.

### BRIEF DESCRIPTION OF THE DRAWINGS

To complete the description and in order to provide for a better understanding of the invention, a set of drawings is provided. Said drawings form an integral part of the description and illustrate preferred embodiments of the invention. The drawings comprise the following figures:
- Figure 1, is a schematic representation of main elements of 3D-printer;
- Figure 2, is a schematic representation an embodiment of a gyroscope according to the manufacturing process of the present invention;
- Figure 3, is a schematic representations of an embodiment of the positioning control tool according to the invention;

### DETAILED DESCRIPTION OF THE DRAWINGS

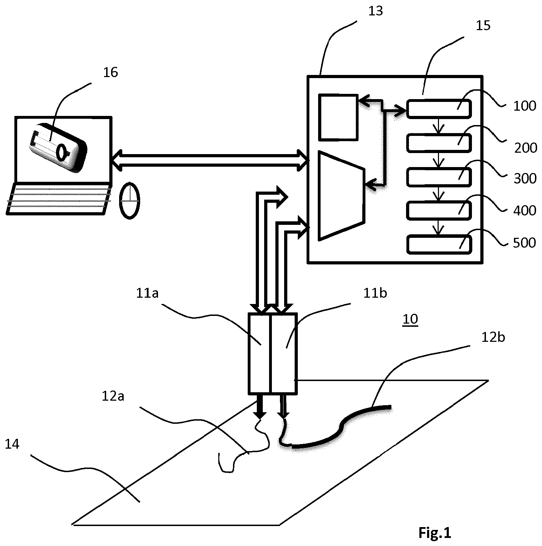

The present invention is directed generally toward the manufacturing process of positioning control tool. A person skilled in the relevant art will understand, however, that the invention may have additional embodiments, and that the invention may be practiced without several of the details of the embodiments described below with reference to figures 1-3.

3D (Three Dimensions) printing, also known as additive layer manufacturing, is increasingly taking importance in all the different industrial sectors. There is infinity of possible applications such as the manufacturing of tools, jigs, parts of simple or complex structure, designed according the needed. This manufacturing via 3D-printing technologies is used especially with the so called Fused Deposition Modelling (FDM) as represented in figure 1.

The Fused Deposition Modelling (FDM), also called FFF (Fused Filament Fabrication) or PJP (Plastic Jet Printing) is an additive manufacturing technology. Additive manufacturing technology is commonly used for thermoplastics 3D-printing with special focus on modeling, prototyping and production applications. The additive manufacturing technology is able to print 3D parts by printing 2D (Two Dimensions) continuous thickness layer, usually called 2,5D (2.5 Dimensions) as there is no coordinated movement in 3D.

The 3D-printing material used to 3D-print consists on a polymer base which can be PLA (Polylactic Acid) or ABS (Acrylonitrile Butadiene Styrene).

According to the invention, the polymer base can be powdered with graphene in order to modify some of its properties. Indeed, graphene is a nanomaterial, discovered in 2004, consisting on a one-atom-thick planar sheet of bonded carbon atoms that are densely packed in a honeycomb crystal lattice. Graphene is a basic structural element of some variants carbon such as graphite, charcoal, nanotubes, and fullerenes. Graphene has unique electronic and mechanical properties, such as:
- a transparency and flexibility;
- a very high thermal and electrical conductivity. Indeed, graphene has a higher conductivity than Cu (copper) or Ag (silver);
- a high elasticity and hardness. Indeed, it is considered as the hardest material ever known;
- a very big lightness. Indeed, graphene is quite as light as the carbon fiber but more flexible;
- enables electrons to flow much faster than silicon;

Consequently, the addition of graphene to some material increases their potential and allows new 3D-printing applications.

Furthermore, graphene opened new ways and new possibilities for the manufacturing of electronic components. Indeed, the possibility to print on sheet active or passive electronic components with graphene, such as semi-conductors, dielectric-interfaces, piezoelectric substrate, transistors, integrated circuits, OLED displays, or organic photovoltaic cells.

Following the different knowledge previously cited, time is come to develop smart device or tool with the 3D-printing technology, but this perspective looks like very complex and expensive according to the state of art.

In order to go on this way, according to figure 1, a 3D-printer 10, able to manufacture a positioning control tool according to the invention, comprises at least a first 3D-printing head **11a** to selectively discharge a conductive 3D-printing material 12a and a second 3D-printing head **11b** to selectively discharge an insulating 3D-printing material 12b. The 3D-printer 10 comprises also a processor 13 able to control the operations of the first and second 3D-printing heads **11a**, **11b**. The processor 13 of the 3D-printer 10 is able to decrypt the list of steps 15 from a CAD (Computer-Aided Design) scheme 16 describing a multi-layer printed circuit board (PCB) intended for 3D-printing.

Each 3D-printing head **11a**, **11b** is able to print in X and Y directions for each layer of conductive or insulating 3D-printing material, such as the 3D-print heads **11a, 11b** or a print bed 14 is able to move before the following layer is printed.

In this kind of technology, the thermoplastic material filament 12a, 12b or wire is heated pass its glass transition temperature of the material and then laid on the print bed 14 or table, where it cools down and consolidates with previous layers in order to create a solid part.

The first and second 3D-printing heads **11a, 11b** are able to 3D-print a functional passive and/or active electrical component, a piezoelectric sensor, piezoelectric substrate, wafer, a functional resistor, a functional capacitor, a functional electromagnetic waveguide, a functional optical waveguide, a functional antenna or protruding antenna or horn antenna, a functional heat sink, a functional coaxial element or coaxial cable or coaxial mesh, a SMT/COB component, or equivalent. By COB component, we understand a Chip-On-Board component assembly.

The first and the second 3D-printing heads **11a, 11b** are able to 3D-print, in a same 3D-printing session, a PCB (Printed Circuit Board) and an electrical component embedded within said PCB.

The first 3D-printing heads **11a** able to discharge the conductive 3D-printing material is associated with at least first and second 3D-printing nozzles (not referenced on the figures). The first 3D-printing nozzle is able to discharge the conductive 3D-printing material through a first nozzle aperture having a first diameter. The second 3D-printing nozzle is able to discharge the conductive 3D-printing material through a second nozzle aperture having a second, different, diameter. In order to switch between the at least first and second 3D-printing nozzle, the 3D-printer **10** comprises a switching module to selectively activate during a 3D-print process, one of the first and second 3D-printing nozzles.

In order to be more efficient, the 3D-printer **10** requires some additional modules. These modules are described below and can be used alone or in combination with others in order to reach the goal expected. This following list of embodiments of additional modules is not exhaustive and can be completed according to the specific needs and the technological advances in the 3D-printer field.

In some embodiments, the 3D-printer **10** comprises an ultraviolet (UV) energy based curing module, to emit ultraviolet radiation for curing 3D-printed materials region-by-region when the 3D-printed materials are being 3D-printed.

In some embodiments, the 3D-printer **10** comprises a laser source to emit a laser beam for curing 3D-printed materials region-by-region when the 3D-printed materials are being 3D-printed.

In some embodiments, the 3D-printer **10** comprises a laser source to emit a targeted laser beam for curing just-dispensed 3D-printed materials.

According to the invention, the 3D-printer **10** is able to proceed to a transition between two crossed conductive materials, with the following sequential 3D-printing steps:
- a first trace of a conductive material **12a**;
- on the top of a particular spot of the first trace, a bridge formed from an insulating material **12b**,
- on the top of the bridge, a second trace of conductive material **12a**.

In some embodiments, the 3D-printer **10** comprises an Automatic Optical Inspection (AOI) module able sequentially to:
- capture an image of a 3D-printed conductive trace during an ongoing 3D-printing session;
- compare the captured image to a reference indicating a required width of the 3D-printed conductive trace;
- based on the comparison, determine that a width of at least a portion of the 3D-printed conductive trace is smaller than the required width;
- trigger a corrective 3D-printing operation to increase the width of said portion of the 3D-printed conductive trace.

In some embodiments, the 3D-printer **10** comprises an Automatic Optical Inspection (AOI) module sequentially able to:
- capture an image of 3D-printed conductive trace during an ongoing 3D-printed session;
- compare the captured image to a reference indicating a required width of the 3D-printed conductive trace;
- based on the comparison, determine that a width of at least a portion of the 3D-printed conductive trace is greater than the required width;
- trigger a laser ablation module to decrease the width of said portion of the 3D-printed conductive trace.

In some embodiments, the 3D-printer **10** comprises an Automatic Optical Inspection (AOI) module sequentially able to :
- capture an image of 3D-printed conductive trace during an ongoing 3D-printing session;
- compare the captured image to a reference indicating a required structure of the 3D-printed conductive trace;
- based on a comparison, identify a fracture in the 3D-printed conductive trace;
- trigger a corrective 3D-printing operation to 3D-print again, correctly, at least a region comprising said fracture.

In some embodiment, the 3D-printer **10** comprises an Automatic Optical Inspection (AOI) module sequentially able to:
- capture an image of a 3D-printed pad of during an ongoing 3D-printing session of a 3D-printed PCB;
- compare the captured image to a reference indicating a required structure of the 3D-printed pad;
- based on the comparison, determine that the 3D-printed pad is excessively large;
- trigger a laser ablation module to decrease the size of said 3D-printed pad.

In some embodiments, the 3D-printer **10** comprises a solder mask 3D-printing module able to 3D-print a solder mask with conductive material **12a** on a 3D-printed PCB, wherein the solder mask and the PCB are 3D-printed in a single, unified, 3D-printing process.

In some embodiments, the 3D-printer **10** comprises a heat sink 3D-printing module to 3D-print a thermally-conductive heat sink integrated in a pre-defined region of a 3D-printed PCB being 3D-printed.

In some embodiments, the 3D-printer **10** comprises a thermal conductivity planner able to:
- determine that a particular region of a PCB being 3D-printed, being located under a 3D-printed conductive pad, requires a heat transfer path with increased thermal conductivity;
- 3D-print, in a region under said 3D-printed conductive pad, with a first 3D-printing material having increased thermal conductivity relative to a second 3D-printing material used for 3D-printing at a surrounding region which does not require a heat transfer path with increased thermal conductivity.

In some embodiments, the 3D-printer **10** comprises a thermal conductivity planner able to:
- determine that a particular region of a PCB being 3D-printed requires a heat transfer path with increased thermal conductivity;
- 3D-print, at said particular region of the PCB being 3D-printed, an electrically conductive path extending from said particular region downwardly to a 3D-printed heat sink at a bottom portion of said PCB being 3D-printed.

In some embodiments, the 3D-printer **10** comprises an embedded SMT component 3D-printing module, to 3D-print a 3D-printed PCB having a fully-buried (unexposed 3D-printed Surface-Mount Technology (SMT) component.

In some embodiments, the 3D-printer **10** comprises a pause-and-resume 3D-printing controller, able to:
- pause a 3D-printing process of a PCB being 3D-printed, and
- wait until a COB/SMT component is assembled onto an already-3D-printed portion of the PCB on top of the COB/SMT that was 3D-printed.

In some embodiments, the 3D-printer **10** comprises a module able to modify the trace width/thickness, during a 3D-printing process of a conductive trace, at least one of
- a width of the constructive trace being 3D-printed, and
- a thickness of the conductive trace being 3D-printed;
wherein said module is able to modify trace width/thickness of the conductive trace while maintaining a fixed current-carrying capacity of said conductive trace.

In some embodiments, the 3D-printer **10** comprises a module able to modify the rigidity and/or flexibility when said 3D-printer **10** needs to 3D-print a PCB having a gradually-changing level of rigidity.

In some embodiments, the 3D-printer **10** comprises a module able to modify the rigidity and/or flexibility when said 3D-printer **10** needs to 3D-print a PCB having an abruptly-changing level of rigidity.

In some embodiments, the 3D-printer **10** comprises a module able to modify a dielectric material thickness when said 3D-printer **10** needs to 3D-print, between a first 3D-printed conductive layer and a second, neighboring, non-parallel, 3D-printed conductive layer, a dielectric material having varying thickness.

In some embodiments, the 3D printer **10** is able to 3D-print a conductive material to create a three-dimensional structure of a first layer of a PCB and a second, non-parallel, layer of the PCB.

According to the invention, the 3D-printer **10** is able to 3D-print a positioning control tool. In order to manufacture that, the manufacturing process comprises the following steps in order to form a gyroscope:
- 3D-print **100** a first part of framework **110** with the insulating material **12b**, such as to form a recipient laid on the print bed **14**,
- 3D-print **200** a set of layers of piezoelectric substrate **205** inside the first part of framework **110** based on the polymer material mixed with powdered graphene **12a** inside said first part of framework **110**;
- 3D-print **300** a pattern **310** having a plurality of apertures **320** therethrough;
- 3D-print **400** with a polymer material mixed with powdered graphene **12a**, using said pattern **310**, a plurality of features **410** on said substrate **205**, said features **410** comprising:
   - a resonator **411** transducer for creating a first surface acoustic wave 215 on said surface **210** of the piezoelectric substrate **205**;
   - a pair of reflectors **412a**, **412b** for reflecting said first surface acoustic wave **215** to form a standing wave within a first region **220** of said surface **210** between said pair of reflectors **412**;
   - a structure **413** within said region **220**, wherein a Coriolis force acting upon said structure **413** creates a second surface acoustic wave **230**, and
   - a first sensor transducer **414** disposed on said surface **210** for sensing said second surface acoustic wave **230**, and
   - a second sensor transducer **415** disposed on said surface **210** for sensing a residual surface acoustic wave from a second region of said surface **210** that is free of any structure that said Coriolis force can act upon, and for providing an output indicative of said residual surface acoustic wave;
- 3D-print **500** a second part of framework **510** with the insulating polymer material **12b**, such as to form a complete framework to protect and guaranty the working of the piezoelectric substrate **205** with the features **410** embedded.

One advantage of this embodiment is the possibility to use the ALM (Additive Laser Manufacturing) in order to manufacture/3D-print quickly any simple or complex piezoelectric substrate **205**, patterns **310**, features **410**, or frameworks **110**, **510** according to an ad-hoc design. Another advantage of this embodiment is the possibility to modify the shape or restyle partially or totally the framework **110**, **510**.

According to the invention, the polymer material used to manufacture the positioning control tool is a base of PLA (Polylactic Acid) or ABS (Acrylonitrile Butadiene Styrene).

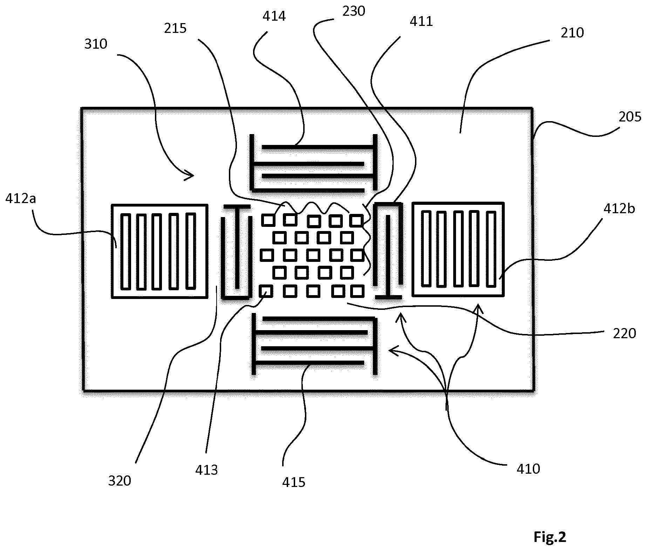

Figure 2 is an embodiment of a gyroscope according to the manufacturing process of the present invention. The gyroscope comprises a piezoelectric substrate **205**, a pair of resonator transducers **411a**, **411b**, a pair of reflectors **412a**, **412b,** at least one, and preferably a plurality of structures **413**, and a pair of sensory transducers **414**, **415**.

The piezoelectric substrate **205** has a surface **210** upon which the other components of gyroscope are disposed. The pair of resonator transducers **411a**, **411b** is disposed on the surface **210**, for creating a first surface acoustic wave **215** on the surface **210**. More particularly, the pair of resonator transducers **411a**, **411b** creates an electrical potential on the substrate **205**, and the substrate **205** convert the electrical potential into mechanical energy, thus forming the first surface acoustic wave **215**. The resonator transducers **411a**, **411b** have fingers spaced with a periodicity of half of the wavelength of the first surface acoustic wave **215**.

The pair of reflectors **412a**, **412b**, is disposed on the surface **210** for reflecting the first surface acoustic wave **215** to form a standing wave within a region **220** of the surface **210,** which is located between the pair of reflectors **412a, 412b.** The reflectors are separated from each other by a distance that is an integral number of one half wavelengths of the first surface acoustic wave.

The structure **413** comprises a set of elements disposed on the surface **210** within region **220.** A Coriolis force acting upon the plurality of elements of the structure **413** creates a plurality of second surface acoustic waves **230.**

The pair of sensors transducers **414, 415** is disposed on the surface **210,** separated together and disposed orthogonally to the pair of resonator transducers **411a, 411b** for sensing the second surface acoustic wave and providing an output indicative of the characteristic of the second surface acoustic wave.

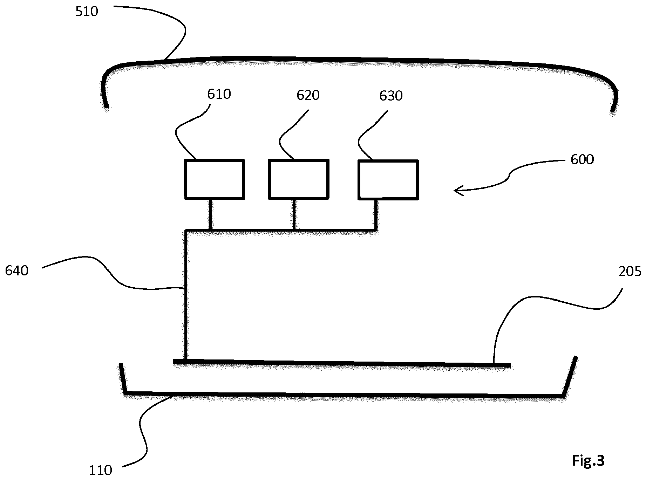

According to the invention, as shown figure 3, the positioning control tool is able to comprise a circuit board **600** 3D-printed, partially or totally embedded within the first part **110** or the second part **510** of the framework such as the circuit board **600** comprises:
- a set of sensors **610** able to be connected to the gyroscope via the piezoelectric substrate in order to measure some values to define the angular movement of the tool;
- a set of digital and/or analogic components **620** able to operate respectively digital or analogic signals from the set of sensors **610;**
- at least one IHM (Interface Human Machine) **630** able to allow to an operator or an automaton to interact with the sensors **610** of the positioning control tool;
- at least one conductive trace **640** able to be connected to the set of sensors **610** to respectively the set of digital and/or analogic components **620,** and at least one IHM **630.**

One main advantage of this embodiment is to confer some smart properties to the positioning control tool in order to interact with an operator or an automaton by itself or from a request. Indeed, the operator or the automatons are able to interact directly or indirectly with the positioning control tool via IHM or communication means.

According to the invention, at least one component of the set of digital and/or analogic components **620** is manufactured via 3D printed graphene.

According to the invention, at least one component **620** is a 3D printed Surface-Mount Component (SMT) or a Chip On Board (COB);

According to the invention, the positioning control tool comprises a 3D printed antenna;

According to the invention, the 3D-printed antenna is a RFID (Radio Frequency Identification). One main advantage with the RFID antenna is the ability to transmit, receive and store remote data quickly to a humanoid or an automaton able to communicate with said positioning control tool.

The conductive trace **640** has a thermal conductivity or is able to conduct electricity. According to the invention, the 3D-printer **10** is able to add more or less graphene powder in the conductive material **12a** in order to obtain a trace **640** with a better thermal or electricity conductivity.

According to the invention, the IHM **630** can be a buzzer, and/or a display interface such as LCD or a set of Led to interact easily with the human operator; In the case of the humanoid or automaton, the communication means are more useful in order to have an interaction with the positioning control tool.

By operator we understand a human or humanoid entitled and able to handle with his hand said positioning control tool. By automaton we understand a self-operating machine, or a machine, or a control mechanism designed to automatically follow a predetermined sequence of operations, or respond to predetermined instructions.

According to the invention, the positioning control tool comprises a part relative to the battery in order to feed all the consumers, such as the set of sensors, the set of digital and/or analogic components, and the set of IHM. According to the invention, the battery is rechargeable.

## Claims

1. Manufacturing process of a positioning control tool via 3D-printing technology comprising the following steps in order to form a gyroscope:
- 3D-print (100) a first part of framework (110) with an insulating 3D-printing polymer material, such as to form a recipient laid on the print bed (14),
- 3D-print (200) a set of layers of piezoelectric substrate (205) inside the first part of framework based on a polymer material mixed with powdered graphene (12a) inside said first part of framework;
- 3D-print (300) a pattern (310) having a plurality of apertures (320) therethrough;
- 3D-print (400) with a polymer material mixed with powdered graphene (12a), using said pattern (310), a plurality of features (410) on said substrate (205), said features (410) comprising:
- a resonator (411) transducer for creating a first surface acoustic wave (215) on said surface (210) of the piezoelectric substrate (205);
- a pair of reflectors (412a, 412b) for reflecting said first surface acoustic wave (215) to form a standing wave within a first region (220) of said surface (210) between said pair of reflectors (412);
- a structure (413) within said region (220), wherein a Coriolis force acting upon said structure (413) creates a second surface acoustic wave (230); and
- a first sensor transducer (414) disposed on said surface (210) for sensing said second surface acoustic wave (230); and
- a second sensor transducer (415) disposed on said surface (210) for sensing a residual surface acoustic wave from a second region of said surface (210) that is free of any structure that said Coriolis force is able to act upon, and for providing an output indicative of said residual surface acoustic wave;
- 3D-print (500) a second part of framework (510) with an insulating 3D-printing polymer material, such as to form a complete framework to protect and guaranty the working of the piezoelectric substrate (205) with the features (410) embedded.

2. Manufacturing process of a positioning control tool via 3D-printing technology according to claim 1, **characterized in that** the polymer material used to manufacture the positioning control tool is based on PLA (Polylactic Acid) or ABS (Acrylonitrile Butadiene Styrene).

3. Manufacturing process of a positioning control tool via 3D-printing technology according to any claim 1 to 2, **characterized in that** it comprises additional steps in order to 3D-print a circuit board (600) partially or totally embedded within the first part (110) or the second part (510) of the framework such as the circuit board (600) comprises:
- a set of sensors (610) able to be connected to the gyroscope in order to measure some values to define the angular movement of the tool;
- a set of digital and/or analogic components (620) able to operate respectively digital or analogic signals from the set of sensors (610);
- at least one IHM (Interface Human Machine) (630) able to allow to an operator or an automaton to interact with the sensors (610) of the positioning control tool;
- at least one conductive trace (640) able to be connected to the set of sensors (610) to respectively the set of digital and/or analogic components (620), and at least one IHM (630).

4. Manufacturing process of a positioning control tool via 3D-printing technology according to claim 3, **characterized in that** at least one component of the set of digital and/or analogic components (620) are manufactured via 3D printed graphene.

5. Manufacturing process of a positioning control tool via 3D-printing technology according to claims 3 or 4, **characterized in that** at least one component (620) is a 3D-printed Surface-Mount Component (SMT).

6. Manufacturing process of a positioning control tool via 3D-printing technology according to claims 3 to 5, **characterized in that** the positioning control tool comprises a 3D-printed antenna.

7. Manufacturing process of a positioning control tool via 3D-printing technology according to claim 6, **characterized in that** the 3D-printed antenna is a RFID (Radio Frequency Identification).

8. Manufacturing process of a positioning control tool via 3D-printing technology according to claims 3 to 7, **characterized in that** the IHM (630) can be a buzzer, and/or a display interface such as LCD or a set of Led.

## Patentansprüche

1. Herstellungsverfahren eines Positionierungssteuerungswerkzeugs mittels 3D-Drucktechnologie, umfassend die folgenden Schritte, um ein Gyroskop zu bilden:
- 3D-Drucken (100) eines ersten Teils des Gerüsts (110) mit einem isolierenden 3D-Druckpolymermaterial, um so einen Träger zu bilden, der auf das Druckbett (14) gelegt worden ist,
- 3D-Drucken (200) eines Satzes von Schichten aus piezoelektrischem Substrat (205) innerhalb des ersten Teils des Gerüsts basierend auf einem Polymermaterial, das mit pulverisiertem Graphen (12a) gemischt ist, innerhalb des ersten Teils des Gerüsts;
- 3D-Drucken (300) eines Musters (310) mit einer Vielzahl von Durchbrüchen (320) durch dieses hindurch;
- 3D-Drucken (400) einer Vielzahl von Merkmalen (410) auf das Substrat (205) mit einem Polymermaterial, das mit pulverisiertem Graphen (12a) gemischt ist, unter Verwendung des Musters (310), wobei die Merkmale (410) umfassen:
- einen Resonatorwandler (411) zum Erzeugen einer ersten akustischen Oberflächenwelle (215) auf der Oberfläche (210) des piezoelektrischen Substrats (205);
- ein Paar Reflektoren (412a, 412b) zum Reflektieren der ersten akustischen Oberflächenwelle (215), um eine stehende Welle innerhalb einer ersten Region (220) der Oberfläche (210) zwischen dem Paar von Reflektoren (412) zu bilden;
- eine Struktur (413) innerhalb der Region (220), wobei eine Corioliskraft, die auf die Struktur (413) einwirkt, eine zweite akustische Oberflächenwelle (230) erzeugt; und
- einen ersten Sensorwandler (414), der auf der Oberfläche (210) angeordnet ist, um die zweite akustische Oberflächenwelle (230) abzufühlen; und
- einen zweiten Sensorwandler (415), der auf der Oberfläche (210) angeordnet ist, um eine restliche akustische Oberflächenwelle von einer zweiten Region der Oberfläche (210) abzufühlen, die frei von jedweder Struktur ist, auf welche die Corioliskraft einwirken kann, und um eine Ausgabe bereitzustellen, welche die restliche akustische Oberflächenwelle angibt;
- 3D-Drucken (500) eines zweiten Teils des Gerüsts (510) mit einem isolierenden 3D-Druckpolymermaterial, um so ein vollständiges Gerüst zu bilden, um das Arbeiten des piezoelektrischen Substrats (205) mit den eingebetteten Merkmalen (410) zu schützen und zu gewährleisten.

2. Herstellungsverfahren eines Positionierungssteuerungswerkzeugs mittels 3D-Drucktechnologie nach Anspruch 1, **dadurch gekennzeichnet, dass** das zur Herstellung des Positionierungssteuerungswerkzeugs verwendete Polymermaterial auf PLA (Polymilchsäure) oder ABS (Acrylnitril-Butadien-Styrol) basiert.

3. Herstellungsverfahren eines Positionierungssteuerungswerkzeugs mittels 3D-Drucktechnologie nach einem der Ansprüche 1 oder 2, **dadurch gekennzeichnet, dass** es zusätzliche Schritte umfasst, um eine Schaltplatine (600) teilweise oder vollständig innerhalb des ersten Teils (110) oder des zweiten Teils (510) des Gerüsts eingebettet mittels 3D-Druck zu drucken, so dass die Schaltplatine (600) umfasst:
- einen Satz von Sensoren (610), der an das Gyroskop angeschlossen werden kann, um einige Werte zu messen, um die Winkelbewegung des Werkzeugs zu definieren;
- einen Satz von digitalen und/oder analogen Komponenten (620), die in der Lage sind, mit digitalen beziehungsweise analogen Signalen von dem Satz der Sensoren (610) zu operieren;
- mindestens eine IHM (Mensch-Maschinen-Schnittstelle) (630), die in der Lage ist, einer Bedienungsperson oder einem Automaten das Interagieren mit den Sensoren (610) des Positionierungssteuerungswerkzeugs zu ermöglichen;
- mindestens eine Leiterbahn (640), die an den Satz von Sensoren (610) an den jeweiligen Satz von digitalen und/oder analogen Komponenten (620) und mindestens eine IHM (630) angeschlossen werden kann.

4. Herstellungsverfahren eines Positionierungssteuerungswerkzeugs mittels 3D-Drucktechnologie nach Anspruch 3, **dadurch gekennzeichnet, dass** mindestens eine Komponente des Satzes von digitalen und/oder analogen Komponenten (620) mittels 3D-gedrucktem Graphen hergestellt wird.

5. Herstellungsverfahren eines Positionierungssteuerungswerkzeugs mittels 3D-Drucktechnologie nach Anspruch 3 oder 4, **dadurch gekennzeichnet, dass** mindestens eine Komponente (620) eine 3D-gedruckte oberflächenmontierbare Komponente (SMT) ist.

6. Herstellungsverfahren eines Positionierungssteuerungswerkzeugs mittels 3D-Drucktechnologie nach den Ansprüchen 3 bis 5, **dadurch gekennzeichnet, dass** das Positionierungssteuerungswerkzeug eine 3D-gedruckte Antenne umfasst.

7. Herstellungsverfahren eines Positionierungssteuerungswerkzeugs mittels 3D-Drucktechnologie nach Anspruch 6, **dadurch gekennzeichnet, dass** die 3D-gedruckte Antenne eine RFID (Identifizierung mit Hilfe elektromagnetischer Wellen) ist.

8. Herstellungsverfahren eines Positionierungssteuerungswerkzeugs mittels 3D-Drucktechnologie nach den Ansprüchen 3 bis 7, **dadurch gekennzeichnet, dass** die IHM (630) ein Signaltongeber und/oder eine Anzeigeschnittstelle sein kann, wie LCD oder ein Satz von LEDs.

## Revendications

1. Procédé de fabrication d'un outil de contrôle de positionnement par une technologie d'impression 3D comprenant les étapes suivantes dans l'ordre pour former un gyroscope :
- impression 3D (100) d'une première partie d'armature (110) avec un matériau polymère d'impression 3D isolant, de manière à former un récipient déposé sur le lit d'impression (14) ;
- impression 3D (200) d'un ensemble de couches de substrat piézoélectrique (205) à l'intérieur de la première partie d'armature sur la base d'un matériau polymère mélangé à du graphène en poudre (12a) à l'intérieur de ladite première partie d'armature ;
- impression 3D (300) d'un motif (310) ayant une pluralité d'ouvertures (320) le traversant ;
- impression 3D (400), avec un matériau polymère mélangé à du graphène en poudre (12a), au moyen dudit motif (310), d'une pluralité d'éléments (410) sur ledit substrat (205), lesdits éléments (410) comprenant :
- un transducteur résonateur (411) pour créer une première onde acoustique de surface (215) sur ladite surface (210) du substrat piézoélectrique (205) ;
- une paire de réflecteurs (412a, 412b) pour réfléchir ladite première onde acoustique de surface (215) pour former une onde stationnaire à l'intérieur d'une première région (220) de ladite surface (210) entre ladite paire de réflecteurs (412) ;
- une structure (413) à l'intérieur de ladite région (220), une force de Coriolis agissant sur ladite structure (413) créant une deuxième onde acoustique de surface (230) ; et
- un premier transducteur détecteur (414) disposé sur ladite surface (210) pour détecter ladite deuxième onde acoustique de surface (230) ; et
- un deuxième transducteur détecteur (415) disposé sur ladite surface (210) pour détecter une onde acoustique de surface résiduelle provenant d'une deuxième région de ladite surface (210) qui est dépourvue de toute structure sur laquelle peut agir ladite force de Coriolis, et pour fournir une sortie indicative de ladite onde acoustique de surface résiduelle ;
- impression 3D (500) d'une deuxième partie d'armature (510) avec un matériau polymère d'impression 3D isolant, de manière à former une armature complète pour protéger et garantir le fonctionnement du substrat piézoélectrique (205) avec les éléments (410) incorporés.

2. Procédé de fabrication d'un outil de contrôle de positionnement par une technologie d'impression 3D selon la revendication 1, **caractérisé en ce que** le matériau polymère utilisé pour fabriquer l'outil de contrôle de positionnement est basé sur le PLA (acide polylactique) ou l'ABS (acrylonitrile-butadiène-styrène).

3. Procédé de fabrication d'un outil de contrôle de positionnement par une technologie d'impression 3D selon l'une quelconque des revendications 1 et 2, **caractérisé en ce qu'**il comprend des étapes supplémentaires afin d'imprimer en 3D une carte de circuit (600) partiellement ou totalement incorporée à l'intérieur de la première partie (110) ou la deuxième partie (510) de l'armature de telle sorte que la carte de circuit (600) comprend :
- un ensemble de capteurs (610) pouvant être reliés au gyroscope afin de mesurer certaines valeurs pour définir le déplacement angulaire de l'outil ;
- un ensemble de composants numériques et/ou analogiques (620) pouvant exploiter des signaux respectivement numériques ou analogiques provenant de l'ensemble de capteurs (610) ;
- au moins une IHM (interface homme-machine) (630) pouvant permettre à un opérateur ou un automate d'interagir avec les capteurs (610) de l'outil de contrôle de positionnement ;
- au moins une piste conductrice (640) pouvant être reliée à l'ensemble de capteurs (610) à respectivement l'ensemble de composants numériques et/ou analogiques (620) et au moins une IHM (630).

4. Procédé de fabrication d'un outil de contrôle de positionnement par une technologie d'impression 3D selon la revendication 3, **caractérisé en ce qu'**au moins un composant de l'ensemble de composants numériques et/ou analogiques (620) est fabriqué par l'intermédiaire de graphène imprimé en 3D.

5. Procédé de fabrication d'un outil de contrôle de positionnement par une technologie d'impression 3D selon les revendications 3 et 4, **caractérisé en ce qu'**au moins un composant (620) est un composant pour montage en surface (SMT) imprimé en 3D.

6. Procédé de fabrication d'un outil de contrôle de positionnement par une technologie d'impression 3D selon les revendications 3 à 5, **caractérisé en ce que** l'outil de contrôle de positionnement comprend une antenne imprimée en 3D.

7. Procédé de fabrication d'un outil de contrôle de positionnement par une technologie d'impression 3D selon la revendication 6, **caractérisé en ce que** l'antenne imprimée en 3D est une RFID (identification par radiofréquence).

8. Procédé de fabrication d'un outil de contrôle de positionnement par une technologie d'impression 3D selon les revendications 3 à 7, **caractérisé en ce que** l'IHM (630) peut être un avertisseur, et/ou une interface d'affichage telle qu'un LCD ou un ensemble de LED.
